Europäisches Patentamt

European Patent Office

Office européen des brevets

(11) Veröffentlichungsnummer: **0 680 102 A1**

(12) **EUROPÄISCHE PATENTANMELDUNG**

(21) Anmeldenummer: **95201050.2**

(22) Anmeldetag: **25.04.95**

(51) Int. Cl.⁶: **H01L 39/22**

(30) Priorität: **28.04.94 DE 4414843**

(43) Veröffentlichungstag der Anmeldung:
**02.11.95 Patentblatt 95/44**

(84) Benannte Vertragsstaaten:
**CH DE FR GB LI**

(71) Anmelder: **Philips Patentverwaltung GmbH**
**Röntgenstrasse 24**
**D-22335 Hamburg (DE)**
㊷ **DE**

(71) Anmelder: **Philips Electronics N.V.**
**Groenewoudseweg 1**
**NL-5621 BA Eindhoven (NL)**
㊷ **CH FR GB LI**

(72) Erfinder: **Krumme, Jens-Peter, Dr., c/o Philips**
**Patentverwaltung GmbH,**
**Wendenstrasse 35c**

**D-20097 Hamburg (DE)**
Erfinder: **Grundler, Dirk, c/o Philips**
**Patentverwaltung GmbH**
**Wendenstrasse 35c**
**D-20097 Hamburg (DE)**
Erfinder: **David, Bernd, Dr., c/o Philips**
**Patentverwaltung**
**GmbH,**
**Wendenstrasse 35c**
**D-20097 Hamburg (DE)**
Erfinder: **Doormann, Volker, c/o Philips**
**Patentverwaltung**
**GmbH,**
**Wendenstrasse 35c**
**D-20097 Hamburg (DE)**

(74) Vertreter: **Hartmann, Heinrich, Dipl.-Ing. et al**
**Philips Patentverwaltung GmbH,**
**Röntgenstrasse 24**
**D-22335 Hamburg (DE)**

(54) **Josephson-Stufenkontakt.**

(57) Die Erfindung betrifft einen Josephson-Stufenkontakt mit einer epitaxial auf einem Substrat aufgewachsenen ersten supraleitenden $YBa_2Cu_3O_7$-Schicht (1), im folgenden YBCO genannt, welche mit einer unter einem Winkel $\alpha < 30°$ verlaufenden Schrägfläche versehen ist, auf welche eine isolierende Barriereschicht (7) und danach eine zweite supraleitende YBCO-Schicht (2) epitaxial aufgebracht sind. Ein hohes $I_o * Rn$-Produkt sowie eine großer Spannungsänderung bei Flußänderung ergibt sich dadurch, daß die Barriereschicht (7) aus $NdGaO_3$-(NGO) oder aus $PrGaO_3$ besteht. Zur Herstellung der Barriereschicht auf einer Basisfläche ist vorgesehen, daß die Basisfläche durch ein Plasma-Ionen-Ätzverfahren vorbehandelt wird, wobei die Plasma-angeregten Ionen auf die Basisfläche mit einer Energie geleitet werden, welche kleiner oder etwa gleich der Energie der Sputterschwelle des Materials der Basisfläche ist.

FIG. 2

Die Erfindung bezieht sich auf einen Josephson-Stufenkontakt mit einer epitaxial auf einem Substrat aufgewachsenen ersten supraleitenden $YBa_2Cu_3O_7$-Schicht, im folgenden YBCO genannt, welche mit einer unter einem Winkel $\alpha < 30°$ verlaufenden Schrägfläche versehen ist, auf welche eine isolierende Barriereschicht und danach eine zweite supraleitende YBCO-Schicht epitaxial aufgebracht sind.

Bei einer derartigen in Appl. Phys. Lett. 61 (14), 1992, Seiten 1709 bis 1711 beschriebenen Anordnung wird eine erste YBCO-Schicht auf ein (001) $SrTiO_3$-Substrat mit zur Substratfläche senkrechter c-Achse epitaxial aufgebracht. Diese Schicht wird mit einer $Y_2O_3$-Isolierschicht versehen. Anschließend wird eine schräge Rampenfläche an einem Ende der ersten YBCO-Schicht durch Ionen-Ätzen erzeugt. Als Barriereschicht wird dann eine dünne $Y_2O_3$-Lage und darauf schließlich die zweite supraleitende YBCO-Schicht aufgebracht. In dieser Druckschrift wird darauf hingewiesen, daß weitere Verbesserungen zur Kontrolle der Qualität des Kontaktes erforderlich sind.

In Appl.Phys.Lett. 59 (8), 1991, Seiten 982 bis 984 wird darauf hingewiesen, daß $NdGaO_3$ und $PrGaO_3$ (PGO) als Barrierenmaterial wegen geringer Mikrowellenverluste Vorteile bieten. Es wurde jedoch festgestellt, daß brauchbare Eigenschaften des PGO als alleiniges Barrierematerial nicht erreichbar sind. Es entstehen nämlich "pin holes" und damit Mikrobrücken zwischen den YBCO-Schichten. Dadurch wird die Wirkung der schwach koppelnden Isolierschicht beeinträchtigt.

Der Erfindung liegt die Aufgabe zugrunde, einen Josephson-Stufenkontakt der eingangs genannten Art zu schaffen, welcher ein hohes $I_o * Rn$-Produkt ($I_o$ = kritischer Strom, Rn = normalleitender Widerstand) sowie eine große Spannungsänderung bei Flußänderung liefert und welcher auch bei geringer Schichtdicke mit guter Qualität und streuungsarm herstellbar ist.

Die Lösung gelingt dadurch, daß die Barriereschicht aus $NdGaO_3$ oder aus $PrGaO_3$ besteht.

Speziell bei Schrägflächen bzw. Rampen aufweisenden Josephson-Stufenkontakten (ramped edge junction) sind hervorragende Betriebsdaten erreicht worden, wenn erfindungsgemäß vorgeschlagenes Material für die Barriereschicht verwendet wird. Bei zweckmäßiger Wahl und sorgfältiger Einhaltung der Verfahrensparameter sind pin holes selbst dann vermeidbar, wenn die Dicke der Barriereschicht im Bereich der Kohärenzlänge des betreffenden Materials gewählt wird.

Der Erfindung liegt weiterhin die Aufgabe zugrunde, ein Verfahren zur Herstellung einer dünnen epitaxialen Schicht auf einer Basisfläche, insbesondere einer Barriereschicht eines Josephson-Kontaktes auf einer supraleitenden YBCO-Schicht, wobei die Basisfläche vor dem Aufwachsen der dünnen epitaxialen Schicht durch ein Plasma-Ionen-Ätzverfahren fein bearbeitet wird, anzugeben, welches eine gleichmäßige Benetzung der Basisfläche ermöglicht. Die Lösung gelingt dadurch, daß die Plasma-angeregten Ionen auf die Basisfläche mit einer Energie geleitet werden, welche kleiner oder etwa gleich der Energie der Sputterschwelle des Materials der Basisfläche ist.

Eine derart vorbehandelte Basisfläche ist besonders glatt. Störstellen bzw. Gitterdefekte aufweisende Kristallelemente sind weitgehend entfernt. Infolgedessen können dünne Schichten gleichmäßig, im Falle eines Einkristalls epitaktisch kohärent, aufwachsen. Nicht benetzte Flächenbereiche (Löcher bzw. pin holes) wurden selbst bei nur 2nm dicken Schichten nicht festgestellt. Bei dem erfindungsgemäßen Verfahren wirken Ionen wegen ihrer geringen kinetischen Energie nur auf die Grenzfläche ein und erzeugen selbst keine Störstellen.

Damit eine derart behandelte Basisfläche vor der darauffolgenden Beschichtung nicht durch atmosphärische Gase, Feuchtigkeit oder Partikel verschlechtert wird, ist vorgesehen, daß die Feinbearbeitung und die Aufbringung der dünnen epitaxialen Schicht in-situ durchgeführt werden.

Das erfindungsgemäße Verfahren ermöglicht das Freiätzen der ungestörten Gitterstruktur einer chemisch beispielsweise durch Atmosphäreneinflüsse und/oder physikalisch beispielsweise durch das Ionenstrahl-Ätzen veränderten Oberfläche, so daß ein ungestörtes und gleichmäßiges epitaktisches Wachstum von Deckschichten mit ähnlicher Gitterstruktur und wenig abweichenden Gitterkonstanten möglich ist. Epitaktische einkristalline kohärente Grenzschichten mit nanometerscharfer Grenzfläche und nanometerkleiner Rauhigkeit werden insbesondere bei SIS-Josephson-Kontakten und in der Halbleitertechnik benötigt. Dieses Verfahren ist auch zur rückstandslosen trockenen Beseitigung (Veraschung) der z. B. für die Ionenstrahl-Ätzung der Schrägflächen von Josephson-Stufenkontakten benötigten Photolackmaske geeignet. Die Lackveraschung kann gleichzeitig mit der Konditionierung der ionenstrahlgeätzten Rampe oder ähnlicher Oberflächen erfolgen und erfordert daher nicht den schädlichen ex-situ-Schritt in Lösungsmitteln. Mit dem sanft wirkenden erfindungsgemäßen Verfahren können also auch anorganische Restbestandteile des Photolacks (z.B. etwa 10 ppm Fe) beseitigt und eine für die nachfolgende Epitaxie geeignete Oberfläche geschaffen werden.

Insbesondere im Falle der Bearbeitung von YBCO-Schichten für Josephson-Kontakte wird bevorzugt, daß ein Sauerstoff-Plasma verwendet wird. Der im Plasmastrom enthaltene atomare Sauerstoff oxidiert das YBCO-Gitter auf, so daß bei vorangehenden Verfahrensschritten wie z.B. bei Ionen-Ätzen einer Rampe oberflächlich beeinträchtigte supraleitende Eigenschaften der YBCO-Schicht wieder hergestellt werden. Bei einer Verfahrenstemperatur von mehr als 600° C können auch Gitterdefekte ausheilen.

Eine zur Ausübung des erfindungsgemäßen Verfahrens besonders geeignete Vorrichtung ist dadurch gekennzeichnet, daß sie in einem Vakuumbehälter eine Plasmaquelle zur Bildung ionisierter Gasteilchen enthält, welche gegenüber einem Substrathalter angeordnet ist, und daß an den Substrathalter eine hochfrequente Spannung angelegt ist, deren Leistung und/oder Spannung derart einstellbar sind, daß die ionisierten Gasteilchen mit einer Energie auf ein auf dem Substrathalter angeordnetes zu bearbeitendes Element auftreffen, welche kleiner als oder im Bereich der Sputterschwelle des Materials des zu bearbeitenden Elements ist. Bei einer solchen Vorrichtung erfolgt die Plasmaerregung der für das Ionen-Ätzen benötigten Gase unabhängig von der Zufuhr der für den Ätzvorgang erforderlichen Energie. Damit ist eine individuelle Einstellung der Ätzenergie und insbesondere auch die Einstellung und Einhaltung einer für einen sanften Ätzvorgang erforderlichen relativ niedrigen Ätzenergie möglich.

Ein in-situ Verfahren wird dadurch ermöglicht, daß im Vakuumbehälter eine Einrichtung zur epitaxialen Beschichtung angeordnet ist.

Die Erfindung wird unter Bezugnahme auf die Zeichnung näher erläutert.

Fig. 1     zeigt die Aufsicht auf ein zwei Josephson-Stufen kontakte enthaltendes SQUID.

Fig. 2     zeigt in vergrößerter Darstellung einen Schnitt durch einen Josephson-Stufenkontakt des SQUIDS nach Fig. 1

Fig. 3     zeigt einen Querschnitt im Bereich einer elektri schen Anschlußfläche

Fig. 4     zeigt schematisch die wesentlichen Bestandteile einer erfindungsgemäßen Vorrichtung

Fig. 5     zeigt Kennlinien der sich bei einer Vorrichtung nach Fig. 3 am Substratträger einstellenden Vorspannung.

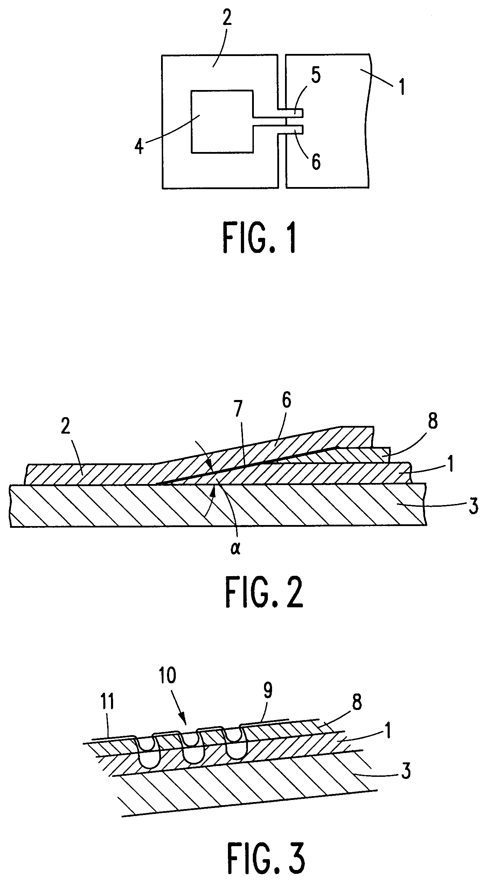

In Fig. 1 sind zwei supraleitende YBCO-Schichten 1 und 2 eines SQUIDS dargestellt, welche epitaxial auf ein (100) $SrTiO_3$-Substrat 3 (Fig. 2) aufgebracht sind. $SrTiO_3$ wird kurz mit STO bezeichnet. Der Bereich 4 (SQUID-Loch) ist schichtfrei. Um diesen Bereich ist eine supraleitende Schleife über zwei Josephsonkontakte gebildet, wobei die Ansätze 5 und 6 der Schicht 2 über eine etwa 2nm dicke NGO-Barriereschicht 7 (Fig. 2) mit der Schicht 1 zur Bildung der Josephson-Stufenkontakte kontaktiert sind.

Der Schichtaufbau im Bereich der Josephson-Stufenkontakte ist in Fig. 2 vergrößert dargestellt.

Zunächst wurden die 200 nm dicke YBCO-Schicht 1 auf dem Substrat 3 mit senkrecht zur Substratfläche verlaufender c-Achse und darauf eine 100 nm dicke epitaktische Isolierschicht 8 (STO oder NGO) abgeschieden. Dazu sind bekannte Verfahren wie Hochfrequenz- Magnetron-Sputtern oder Ionenstrahl-Sputtern geeignet. Danach wurden die YBCO-Schicht 1 und auch die Isolierschicht 8 in bekannter Weise durch Ionenstrahl-Ätzen mit einer unter einem Winkel von $\alpha$ = 15° verlaufenden Schrägfläche versehen.

Durch ein nachfolgend näher erläutertes Plasma-Ionenätzverfahren wurde eine defektarme und sauerstoffgesättigte Grenzfläche auf der Schrägfläche der unteren BCO-Schicht geschaffen, die das epitaktisch-kohärente Aufwachsen der folgenden dünnen Barriere und danach auch der zweiten YBCO-Schicht ermöglicht.

Zur Vermeidung von Verunreinigungen durch Atmosphärengase vor der Beschichtung mit der Barriere und der oberen YBCO-Schicht wurde dann die NGO-Barriereschicht 7 und die YBCO-Schicht 2 in-situ epitaxial aufgebracht.

Der Winkel $\alpha$ darf einen Wert von 30° nicht überschreiten, damit insbesondere in der YBCO-Schicht 2 keine Korngrenzen entstehen. Korngrenzen wurden bei $\alpha$ = 10° bis 20° sicher vermieden. Rampen mit dieser Neigung können problemlos hergestellt werden.

Gemäß Fig. 3 wurden elektrische Anschlußflächen 9 (pads) an den YBCO-Schichten 1 und 2 angebracht. Zunächst wurde im Bereich der pads eine Mehrzahl von Löchern 10 (Durchmesser einige $\mu$m) durch die Isolierschicht 8 hindurch bis in die untere YBCO-Schicht hineingeätzt. Die Ätztiefe braucht nicht genau begrenzt zu sein. Die Löcher 10 dürfen vielmehr vorzugsweise bis in das Substrat 3 reichen. Danach wurde zur Bildung der Anschluß-pads eine Silberschicht 11 aufgebracht, welche innerhalb der Löcher 10 eine Mehrzahl von seitlichen Kontaktstellen mit der Schicht 1 bildet. In der beschriebenen Weise können auch supraleitende Verbindungen zwischen zwei supraleitenden Schichten hergestellt werden, wenn statt der Silberschicht 11 eine supraleitende Schicht aufgebracht wird. Dann entstehen in den Löchern großflächige Josephson-Kontakte, die bei entsprechender Anzahl wie ein einziger supraleitender Kurzschluß wirken.

Dünne Barriereschichten ermöglichen bei Josephson-Kontakten ein hohes Produkt Io * Rn. Zwar wächst der Widerstand Rn etwa linear mit der Schichtdicke, aber der kritische Strom Io nimmt etwa exponentiell mit der Schichtdicke ab.

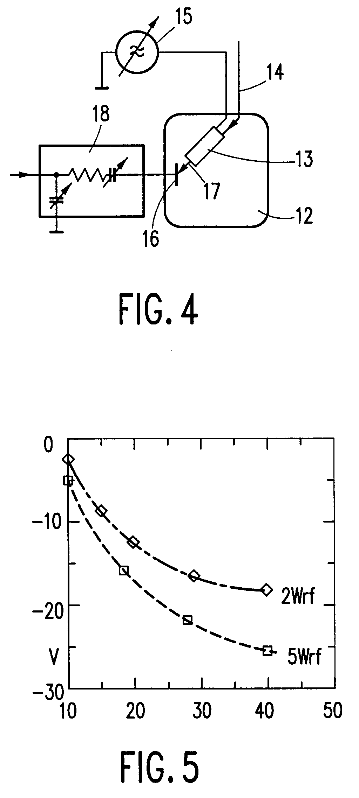

Homogene und pin hole- freie Barriereschichten lassen sich auch im Falle sehr geringer Schichtdicken bei sorgfältiger Verfahrensgestaltung erreichen. Besonders wichtig ist die in-situ Nachbehandlung der Rampenflächen vor dem Aufwachsen der Barriereschicht 7. Dazu wurde ein spezielles Verfahren mit einer in Fig. 4 angedeuteten Vorrichtung verwendet. In einer Vakuumkammer 12 (0,5 bis 2 Pa) ist eine ECR-Sauerstoff-Plasmaquelle 13 angeordnet, welche über die Zuleitung 14 mit $O_2$ - (10 bis 40 sccm) beschickt wird und in welcher mittels des Generators 15 (217 W, 245 GHz) eine Plasmawolke erzeugt wird, welche insbesondere auch atomaren Sauerstoff enthält.

Der teilweise dissozierte und ionisierte Sauerstoff strömt zum Substratträger 16 (Pfeilrichtung 17). Die kinetische Teilenergie wird so eingestellt, daß sie im Bereich der Sputterschwelle des zu behandelnden und auf dem Substratträger anzuordnenden Materials liegt oder vorzugsweise kleiner ist. Das wird erreicht durch eine sich im Bereich zwischen -3V und -30V einstellende Vorspannung am Substratträger 16, indem dazu über den Tuner 18 eine 13,56 MHz-Leistung von weniger als 10 W zugeführt wird. Diese kleine HF-Leistung kann allein kein stabiles Plasma erzeugen, sondern dient nur dazu, die positiven Ionen des Sauerstoffplasmas mit niedriger Energie zum Substratträger zu beschleunigen. Wegen der geringen Energie werden gestörte Zonen der Schrägflächen sanft beseitigt, ohne daß neue Störstellen erzeugt werden. Derart behandelte YBCO-Schichten werden durch den atomaren Sauerstoff oxidiert und die supraleitenden Eigenschaften wieder hergestellt. Bei einer Substrattemperatur von mehr als 600° C heilen auch Gitterdefekte aus.

Fig. 5 zeigt die Abhängigkeit der sich am Substratträger 16 einstellenden Vorspannung V über dem $O_2$-Gasfluß bei HF-Leistungen von 2 Wrf und 5 Wrf.

Das beschriebene Verfahren zum Hochfrequenz-Plasmaätzen mit sehr niedrigen Ionenenergien ist allgemein anwendbar, wenn epitaxielfähige Schichten hoher Qualität erzeugt werden sollen. Es ist besonders vorteilhaft anwendbar bei der Herstellung von Josephson-Stufenkontakten zur Vorbehandlung von YBCO-Flächen.

Um eine nachträgliche Beeinträchtigung der durch das erfindungsgemäß sanfte Ionenplasma-Ätzen behandelten Flächen zu vermeiden, sollte das nachfolgende epitaxiale Aufwachsen von Schichten in situ erfolgen. Dazu sind in der Vakuumkammer nach Fig. 4 entsprechende Einrichtungen zum Beschichten anzuordnen. Der Substratträger 16 ist dann zweckmäßig innerhalb des Vakuumbehälters zu diesen Einrichtungen verfahrbar.

An erfindungsgemäßen Josephson-Stufenkontakten wurden bei 2 nm dicken NGO-Barrieren folgende Werte gemessen:
Io * Rn = 115 $\mu$V bei 77K bzw. 5 mV bei 4K sowie dV/d$\Phi$ < 50 $\mu$V/$\phi$o.

Bei mit einer 7 nm dicken STO-Barriere hergestellten Josephson-Kontakten wurden demgegenüber folgende Werte erreicht:
Io * Rn = 35 $\mu$V bei 77K und dV/d$\Phi$ = 25 $\mu$V/$\Phi$o. Josephson-Stufenkontakte mit einer 5 nm dicken N-YBCO Barriere ergaben Io * Rn = 1 mV bei 4K.

**Patentansprüche**

1.  Josephson-Stufenkontakt mit einer epitaxial auf einem Substrat aufgewachsenen ersten supraleitenden $YBa_2Cu_3O_7$-Schicht (1), im folgenden YBCO genannt, welche mit einer unter einem Winkel $\alpha<30°$ verlaufenden Schrägfläche versehen ist, auf welche eine isolierende Barriereschicht (7) und danach eine zweite supraleitende YBCO-Schicht (2) epitaxial aufgebracht sind,
    dadurch gekennzeichnet,
    daß die Barriereschicht (7) aus $NdGaO_3$ (NGO) oder aus $PrGaO_3$ besteht.

2.  Verfahren zur Herstellung einer dünnen epitaxialen Schicht auf einer Basisfläche, insbesondere einer Barriereschicht (7) eines Josephson-Kontaktes auf einer supraleitenden YBCO-Schicht (1), wobei die Basisfläche vor dem Aufwachsen der dünnen epitaxialen Schicht durch ein Plasma-Ionen-Ätzverfahren feinbearbeitet wird, dadurch gekennzeichnet, daß die Plasma-angeregten Ionen auf die Basisfläche mit einer Energie geleitet werden, welche kleiner oder etwa gleich der Energie der Sputterschwelle des Materials der Substratfläche ist.

3.  Verfahren nach Anspruch 1,
    dadurch gekennzeichnet, daß die Feinbearbeitung und die Aufbringung der dünnen epitaxialen Schicht in-situ durchgeführt werden.

4.  Verfahren nach einem der Ansprüche 2 oder 3,
    dadurch gekennzeichnet,
    daß die Basisfläche die Schrägfläche einer supraleitenden YBCO-Schicht (1) eines Josephson-Stufenkontakts ist, welche insbesondere durch Ionen-Ätzen hergestellt ist.

5.  Verfahren nach Anspruch 4,
    dadurch gekennzeichnet, daß ein Sauerstoff-Plasma verwendet wird.

6.  Vorrichtung zur Ausübung des Verfahrens nach einem der Ansprüche 2 bis 5,
    dadurch gekennzeichnet,
    daß sie in einem Vakuumbehälter (12) eine Plasmaquelle (13) zur Bildung ionisierter Gasteilchen enthält, welche gegenüber einem Substrathalter (16) angeordnet ist, und daß an den Substrathalter (16) eine hochfrequente Spannung angelegt ist, deren Leistung und/oder Spannung derart einstellbar sind, daß die ionisierten Gasteilchen mit einer Energie auf ein auf dem Substrathalter (16) angeordnetes zu bearbeitendes Element auftreffen, welche kleiner als oder im Bereich der Sputterschwelle des Materials des Elements ist.

7. Vorrichtung nach Anspruch 6,
   dadurch gekennzeichnet, daß im Vakumbehälter (12) eine Einrichtung zur epitaxialen Beschichtung angeordnet ist.

FIG. 1

FIG. 2

FIG. 3

FIG. 4

FIG. 5

**Europäisches Patentamt**

# EUROPÄISCHER RECHERCHENBERICHT

Nummer der Anmeldung

EP 95 20 1050

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | WO-A-94 07270 (CONDUCTUS INC ;CHAR KOOKRIN (US); GEBALLE THEODORE H (US)) 31.März 1994 <br> * Seite 15, Zeile 1; Abbildung 2 * <br> --- | 1 | H01L39/22 |
| X | US-A-5 304 538 (VASQUEZ RICHARD P ET AL) 19.April 1994 <br> * Abbildung 2; Tabelle 2 * <br> --- | 1 | |
| A | APPLIED PHYSICS LETTERS, 10 AUG. 1992, USA, <br> Bd. 61, Nr. 6, ISSN 0003-6951, <br> Seiten 711-713, <br> ROBERTAZZI R P ET AL 'Y/sub 1/Ba/sub 2/Cu/sub 3/O/sub 7//MgO/Y/sub 1/Ba/sub 2/Cu/sub 3/O/sub 7/ edge Josephson junctions' <br> * Seite 711, Spalte 2, Absatz 3 * <br> --- | 1,2 | |
| A | PHYSICA C, 15 OCT. 1990, NETHERLANDS, <br> Bd. 171, Nr. 1-2, ISSN 0921-4534, <br> Seiten 126-130, <br> GAO J ET AL 'Controlled preparation of all high-T/sub c/ SNS-type edge junctions and DC SQUIDS' <br> * Abbildung 1 * <br> ----- | 1 | **RECHERCHIERTE SACHGEBIETE (Int.Cl.6)** <br><br> H01L |

Der vorliegende Recherchenbericht wurde für alle Patentansprüche erstellt

| Recherchenort | Abschlußdatum der Recherche | Prüfer |
|---|---|---|
| DEN HAAG | 8.August 1995 | Pelsers, L |